# EUROPÄISCHE PATENTANMELDUNG

(11) **EP 1 154 485 A1**
(43) Veröffentlichungstag der Anmeldung: **14.11.2001**
(21) Anmeldenummer: 01110571.5
(22) Anmeldetag: 30.04.2001
(51) Int. Cl.: H01L 27/02

(54) **ESD-Schutzstruktur**

(30) Priorität: 08.05.2000 DE 10022368
(71) Anmelder: Micronas GmbH, 79108 Freiburg (DE)
(72) Erfinder: Czech, Martin, 79111 Freiburg (DE); Graf, Peter, 79331 Teuingen-Nimburg (DE)
(74) Vertreter: Patentanwälte Westphal, Mussgnug & Partner

(57) **Zusammenfassung**

Die Erfindung betrifft eine ESD-Schutzstruktur zum Schutz einer zwischen einer ersten Potentialschiene mit einem ersten Versorgungspotential und einer zweiten Potentialschiene mit einem zweiten Versorgungspotential geschalteten, integrierten Halbleiterschaltung vor elektrostatischer Entladung, mit einer Mehrzahl von lateral ausgebildeten Bipolartransistoren, deren Laststrecken parallel zueinander und zwischen den Potentialschienen angeordnet sind und deren Steueranschlüsse an einer der Potentialschienen angeschlossen ist, wobei in die Laststrecke jedes Bipolartransistors jeweils ein kollektorseitig und/oder jeweils ein emitterseitig in die ESD-Schutzstruktur mitintegrierter Bahnwiderstand angeordnet ist.

## Beschreibung

Die Erfindung betrifft eine ESD-Schutzstruktur zum Schutz einer integrierten Halbleiterschaltung vor elektrostatischer Entladung.

Im Betrieb einer integrierten Schaltung kommt es mitunter zu unerwünscht hohen Spannungsspitzen, die über die Versorgungsspannungsleitungen in die integrierte Schaltung eingekoppelt werden. Ohne geeignete Schutzmaßnahmen können bereits parasitäre Überspannungen von wenigen Volt und dadurch verursachte elektrostatische Entladungen (engl.: electrostatic discharge (ESD)) die integrierte Schaltung irreversibel schädigen bzw. im Extremfall sogar zerstören, wodurch die Ausfallrate solcher integrierten Schaltungen unakzeptabel hoch wird.

Zur Verringerung der Ausfallrate enthalten in einem Chip integrierte Halbleiterschaltungen mitintegrierte ESD-Schutzstrukturen zum Schutz gegen elektrostatische Überspannungen. Diese ESD-Schutzstrukturen können als Klemmschaltungen zwischen den Versorgungsspannungsleitungen der integrierten Schaltung eingefügt werden und im Falle einer elektrostatischen Entladung die parasitäre Spannung auf eine der Versorgungsspannungsleitungen ableiten. Auf diese Weise kann die parasitäre Überspannung zwischen den Versorgungsspannungsleitungen auf verträgliche Werte reduziert werden.

Eine wesentliche Randbedingung bei der Herstellung von ESD-Schutzstrukturen ergibt sich aus der Forderung, dass diese unter Operationsbedingungen, wie sie beispielsweise in der Produktspezifikation beschrieben sind, die zu schützende integrierte Schaltung nicht oder nur unwesentlich beeinträchtigen dürfen. Das bedeutet, dass die Durchbruch- bzw. Durchschaltspannung eines ESD-Schutzelementes außerhalb des Signalspannungbereichs der zu schützenden Schaltung liegen muss. Um nun eine gute Schutzwirkung entfalten zu können, sollte das ESD-Schutzelement also vor dem kritischen Schaltungspfad, jedoch noch außerhalb des Signalspannungbereichs durchbrechen. Dies erfordert in der Regel eine sehr exakte Einstellung der Durchbruch- bzw. Durchschaltspannung der jeweiligen ESD-Schutzelemente mit der wesentlichen Randbedingung, dass die Prozessführung, die hinsichtlich der Eigenschaften der Bauelemente der zu schützenden integrierten Schaltung optimiert wurde, durch das Einfügen der ESD-Schutzstruktur nicht oder nur unwesentlich verändert wird.

Als ESD-Schutzstrukturen werden zumindest teilweise sperrende Halbleiterbauelemente, wie beispielsweise Thyristoren, Dioden oder Bipolartransistoren, verwendet.

ESD-Dioden weisen jedoch den Nachteil auf, dass bei sehr hohen Strömen der Spannungsabfall über der Diode mitunter so groß werden kann, dass empfindliche Bauteile der zu schützenden Schaltung, zum Beispiel deren Gateoxide oder Diffusionsgebiete, irreversibel geschädigt werden. Darüber hinaus ist die Leistungsaufnahme der Diode im Rückwärtsbetrieb sehr groß.

Bei ESD-Thyristoren besteht die Gefahr, dass eine einmal gezündete Struktur den gezündeten Zustand unerwünschterweise beibehält. Dieser gezündete Zustand, der beliebig lange andauern kann, kann einen Kurzschluss in der Spannungsversorgung verursachen und führt in der Regel zur Zerstörung der ESD-Schutzstruktur, wodurch der ESD-Schutz für die integrierte Halbleiterschaltung nicht mehr gewährleistet ist.

Aus den oben genannten Gründen werden daher häufig ESD-Schutzstrukturen verwendet, die eine Vielzahl von parallel geschalteten, bipolaren Feldoxidtransistoren als ESD-Schutz aufweisen. Diese ESD-Schutzstrukturen, die sich besonders gut zur Begrenzung von Überspannungen eignen, zeigen bei umgekehrter Vorspannung in der Kennlinie zunächst ein sperrendes Verhalten, bis ein erster Spannungsdurchbruch erreicht ist, bei dem die Stroms-Spannungs-Kennlinie auf eine niedrigere Spannung als die Durchbruchspannung zurückschnappt. Dieses Zurückschnappen auf die niedrigere, sogenannte Haltespannung wird auch als Snapback-Verhalten bezeichnet.

Bei derartigen ESD-Schutzstrukturen ergibt sich bei zunehmender Strukturverkleinerung der integrierten Halbleiterschaltungen, insbesondere bei Strukturbreiten ab < 0,5 µm, das Problem, dass die Haltespannung aufgrund der sehr kleinen lateralen Strukturen in den Bereich der Signalspannung der integrierten Schaltung gelangt. Wird eine solche ESD-Schutzstruktur gezündet, dann verharrt sie in diesem zurückgeschnappten Zustand so lange, bis die Versorgungsspannung abgeschaltet wird. Dieser Zustand führt zu einer sehr großen Leistungsaufnahme der integrierten Schaltung und im Versorgungsspannungsnetzteil, wodurch thermisch bedingte dauerhafte Schäden beim Endverbraucher auftreten können.

Durch thermische Instabilitäten eines ESD-Bipolartransistors kann gleichermaßen die Signalspannung der gesamten integrierten Halbleiterschaltung kurzgeschlossen werden, was ohne weitere Schutzmaßnahmen verheerende Folgen haben kann, die bis zur Zerstörung der integrierten Schaltung führen können. Es besteht somit der Bedarf, dass die Haltespannung auch bei Schwankungen in der Herstellungstechnologie definiert und verlässlich außerhalb des Signalspannungsbereichs liegt. Die Haltespannung sollte also möglichst auf höhere Ströme und Spannungen hinausgeschoben werden.

Der vorliegenden Erfindung liegt daher die Aufgabe zugrunde, eine ESD-Schutzstruktur der eingangs genannten Art bereitzustellen, bei der die Haltespannung derart einstellbar ist, dass sie definiert außerhalb des Signalspannungsbereichs der zu schützenden Schaltung liegt. Ferner sollen thermische Instabilitäten der ESD-Struktur weitestgehend vermieden werden.

Diese Aufgabe wird erfindungsgemäß durch eine ESD-Schutzstruktur mit den Merkmalen des Patentanspruchs 1 gelöst.

Erfindungsgemäß werden die Emitterelektroden und/oder die Kollektorelektroden auf den zu kontaktierenden Bereichen derart angeordnet, dass der mittlere freie Weg von Ladungsträgern zwischen den jeweiligen Elektroden und dem Substrat künstlich vergrößert wird. Diese zusätzlich eingefügten Abstände in den Emitterzonen und Kollektorzonen gehen dabei über das hierfür übliche Maß, die durch die Designregeln vorgegeben sind, deutlich hinaus. Über die besagten Abstände läßt sich ein gewünschter Emitter- und Kollektorbahnwiderstand gezielt und definiert einstellen.

Es wird somit in der Emitterzone ein zusätzlicher, integrierter Emitterbahnwiderstand und in der Kollektorzone ein integrierter, zusätzlicher Kollektorbahnwiderstand eingefügt. Durch Einfügen des Kollektorbahnwiderstandes kann die thermische Instabilität der Bipolartransistoren der ESD-Schutzstruktur weitestgehend vermieden werden, wodurch mithin eine optimale ESD-Schutzwirkung erzielt werden kann. Durch Einfügen des integrierten Emitterbahnwiderstandes, kommt es zu einer Gegenkopplung des Stromes, wodurch erreicht werden kann, dass die zur Erreichung einer ESD-Schutzwirkung erforderliche Haltespannung gefahrlos erreicht wird. Dadurch ist mithin eine definierte Einstellung der Haltespannung möglich.

Typischerweise weisen die Kollektorbahnwiderstände einen deutlich größer Widerstandswert als die Emitterbahnwiderstände auf.

Typischerweise werden die Emitterzonen und die Kollektorzonen von den Basiszonen lateral umschlossen, wodurch ein besserer Latch-Up-Schutz für die ESD-Schutzstruktur gewährleistet ist. Dieser Latch-UP-Schutz kann weiter verbessert werden, indem sämtliche Zonen der ESD-Struktur - dass heißt die Emitterzonen, die Kollektorzonen und die Basiszonen - in eine zusätzliche Wanne eingebettet sind und somit vom Substratpotential abgetrennt sind.

In einer vorteilhaften Ausgestaltung der Erfindung sind die Emitterzonen und Kollektorzonen streifenförmig ausgebildet. Die streifenförmigen Kollektorzonen und Emitterzonen sind dann parallel nebeneinander angeordnet, wobei sich Kollektorzonen und Emitterzonen gegenseitig abwechseln. In einer Weiterbildung dieser Anordnung weist die ESD-Schutzstruktur ein im Wesentlichen quadratisches Layout auf, wodurch eine signifikante Homogenisierung des Stromes der ESD-Struktur gewährleistet wird. Eine weitere Homogenisierung des Stromes kann dadurch erzielt werden, dass die Emitterzonen und Kollektorzonen von den jeweiligen Elektroden durchgehend kontaktiert sind.

Besonders vorteilhaft ist es in diesem Zusammenhang, wenn die streifenförmigen Emitterelektroden und die Kollektorelektroden mit derjenigen Leiterbahn, mit der sie verbunden sind, jeweils eine fingerartige Struktur bilden, die dann ineinander verschränkt sind. Auf diese Weise wird gewährleistet, dass die größten Stromdichten und somit die größten Spannungsabfälle an gegenüberliegenden Seiten der jeweiligen Leiterbahnen entstehen, wodurch durch Spannungsdurchbrüche verursachte Verbrennungen an den Leiterbahnen signifikant reduziert werden.

Die erfindungsgemäße ESD-Schutzstruktur eignet sich insbesondere bei als Feldoxidtransisitoren ausgebildeten Bipolartransistoren.

Vorteilhafte Ausgestaltungen und Weiterbildungen sind den Unteransprüchen, der Beschreibung und den Figuren der Zeichnung entnehmbar.

Die Erfindung wird nachfolgend anhand der in den Figuren der Zeichnung angegebenen Ausführungsbeispiele näher erläutert. Es zeigt dabei:
- Figur 1: eine Schaltungsanordnung mit einer erfindungsgemäßen ESD-Schutzstruktur;
- Figur 2: ein Schaltbild der in Fig. 1 gezeigten erfindungsgemäßen ESD-Schutzstruktur bestehend aus drei Bipolartransistoren;
- Figur 3: in einem Teilschnitt ein Ausführungsbeispiel der in Fig. 2 gezeigten ESD-Schutzstruktur;
- Figur 4: einen vergrößerten Ausschnitt der in Fig. 3 gezeigten ESD-Schutzstruktur,
- Figur 5: in einer Draufsicht ein vorteilhaftes Layout zur Kontaktierung von Emitter, Basis und Kollektor der ESD-Schutzstruktur entsprechend Fig. 3;
- Figur 6: in einer Draufsicht eine vorteilhafte Anordnung der Leiterbahnen zur Kontaktierung der Emitterelektroden und der Kollektorelektroden.

In allen Figuren der Zeichnung sind gleiche bzw. funktionsgleiche Elemente mit gleichen Bezugszeichen versehen worden.

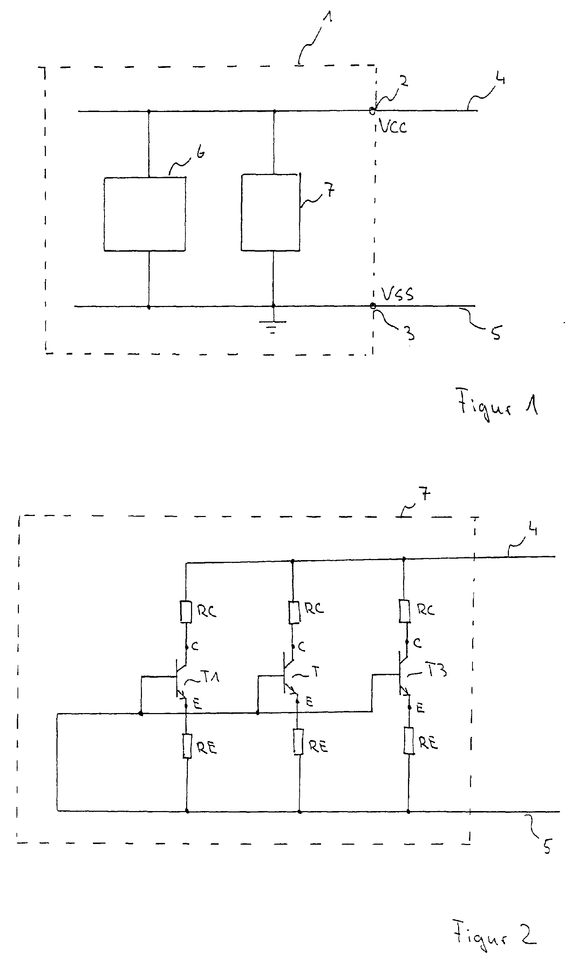

Fig. 1 zeigt eine Schaltungsanordnung mit einer erfindungsgemäßen ESD-Schutzstruktur. In Fig. 1 ist mit 1 die integrierte Halbleiterschaltung bezeichnet. Die integrierte Halbleiterschaltung 1 ist über seine beiden Versorgungspannungseingänge 2, 3 mit einer ersten Potentialschiene 4 mit einem ersten Versorgungspotential VCC sowie einer zweiten Potentialschiene 5 mit einem zweiten Versorgungspotential VSS, dass im vorliegenden Beispiel das Potential der Bezugsmasse ist, verbunden.

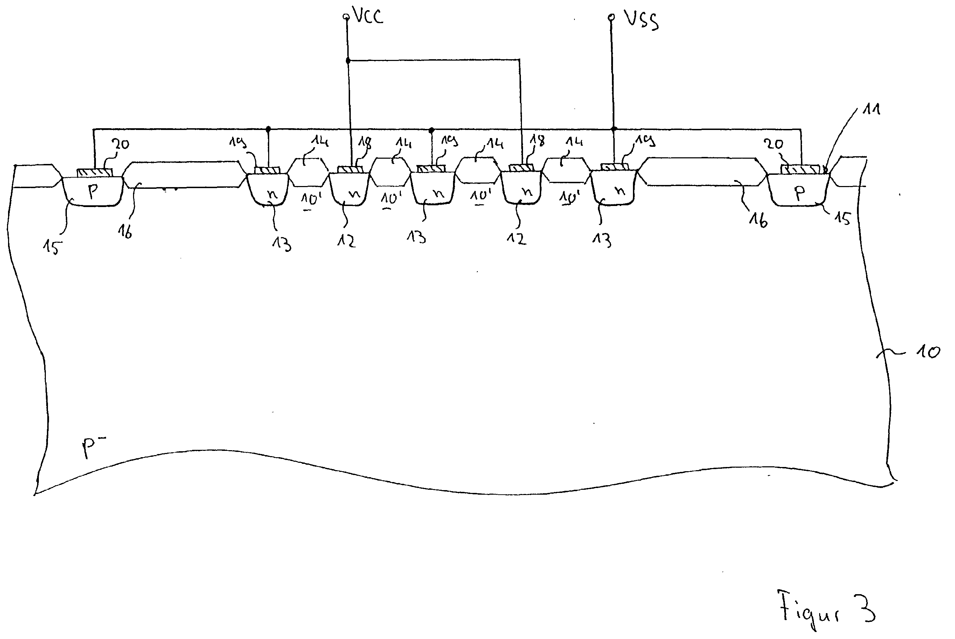

Die integrierte Halbleiterschaltung 1 weist ferner eine zu schützende Schaltung 6, beispielsweise eine Logikschaltung, eine programmgesteuerte Einheit, einen Halbleiterspeicher, eine Leistungsschaltung, etc., auf. Ferner weist die integrierte Halbleiterschaltung 1 eine ESD-Schutzstruktur 7 zum Schutz der zu schützenden Schaltung 6 auf. Die zu schützende Schaltung 6 sowie die ESD-Schutzstruktur 7 sind jeweils zwischen die Potentialschienen 4, 5 geschaltet. Der erfindungsgemäße Aufbau der ESD-Schutzstruktur 7 bzw. vorteilhafte Weiterbildungen werden nachfolgend anhand der Figuren 2 bis 6 ausführlich beschrieben.

Fig. 2 zeigt eine Schaltungsanordnung der in Fig. 1 gezeigten, erfindungsgemäßen ESD-Schutzstruktur. Die ESD-Schutzstruktur 7 weist drei bipolare Feldoxidtransistoren T1, T2, T3 auf. Die Bipolartransistoren T1 - T3 sind über ihre Laststrecken parallel angeordnet und zwischen den Potentialschienen 4, 5 geschaltet, wobei im vorliegenden Ausführungsbeispiel die jeweiligen Emitteranschlüsse E mit dem Potential der Bezugsmasse VSS und die jeweiligen Kollektoranschlüsse C mit dem Versorgungspotential VCC verbunden sind. Erfindungsgemäß ist kollektorseitig und emitterseitig jeweils ein Bahnwiderstand RC, RE in die Laststrecken der Bipolartransistoren T1 - T3 geschaltet. Diese Bahnwiderstände RC, RE sind in die ESD-Schutzstruktur mitintegriert.

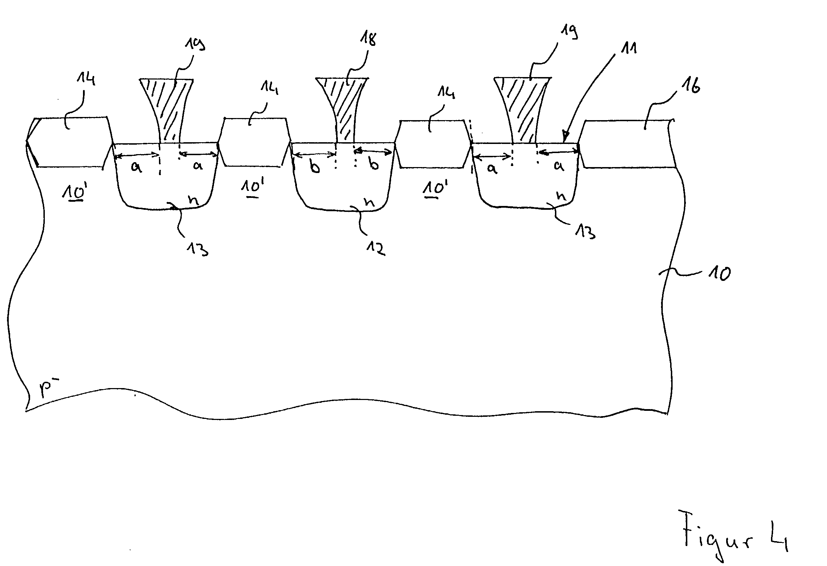

Fig. 3 zeigt in einem Teilschnitt die in Fig. 2 dargestellte ESD-Schutzstruktur. In Fig. 3 ist mit 10 ein Ausschnitt eines Halbleiterkörpers bezeichnet. Der Halbleiterkörper 10 besteht im vorliegenden Ausführungsbeispiel aus schwach p-dotiertem Siliziumsubstrat. Der Halbleiterkörper 10 weist eine Scheibenvorderseite 11 auf, in der erste und zweiten n-dotierte Bereiche 12, 13 eingebettet sind. Die ersten n-dotierten Bereiche 12 sind im vorliegenden Ausführungsbeispiel die Kollektorzonen, die zweiten n-dotierten Bereiche 13 sind die Emitterzonen. Kollektorzonen 12 und Emitterzonen 13 sind im vorliegenden Ausführungsbeispiel an der Oberfläche 11 abwechselnd angeordnet und voneinander durch jeweils eine Substratzone 10' bzw. ein Feldoxid 14 beabstandet. Ferner sind p-dotierte Bereiche 15, die hier die Basiszonen bilden, in den Halbleiterkörper 10 eingebettet. Diese Basiszonen 15 umschließen die Kollektorzonen 12 und Emitterzonen 13 und sind von diesen beispielsweise ebenfalls durch ein Feldoxid 16 beabstandet.

Die Kollektorzonen 12, die Emitterzonen 13 und die Basiszonen 14 weisen an der Oberfläche 11 des Halbleiterkörpers 10 jeweils Metallelektroden 18, 19, 20 auf. Die Kollektorelektroden 18 sind miteinander kurzgeschlossen und mit dem ersten Versorgungspotential VCC verbunden. Die Emitterelektroden 19 und die Basiselektroden 20 sind ebenfalls miteinander kurzgeschlossen und mit dem Potential der Bezugsmasse VSS verbunden.

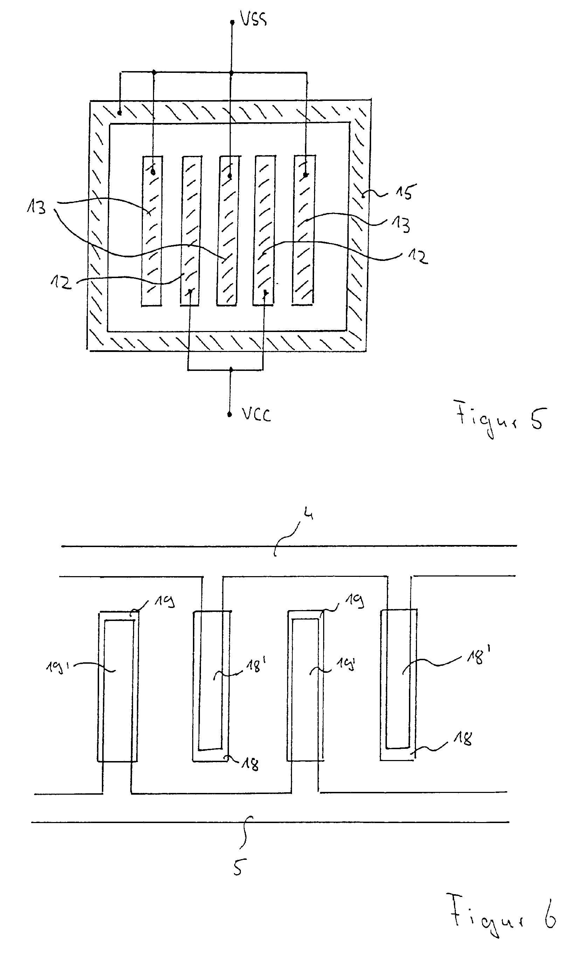

Figur 4 zeigt einen vergrößerten Ausschnitt der in Fig. 3 gezeigten ESD-Schutzstruktur. Der vergrößerte Ausschnitt zeigt, dass die Kollektorelektroden 18 und Emitterelektroden 19 auf den jeweiligen Diffusionsgebieten, die als Kollektorzonen 13 und Emitterzonen 12 ausgebildet sind, größere Abstände a und b zu den Rändern der jeweiligen Diffusionsgebiete aufweisen, als dies von der Technologie über die dort angegebenen Designregeln her gefordert wäre. Diese Abstände a, b wirken sich im Ersatzschaltbild entsprechend Fig. 2 wie Kollektorbahnwiderstände RC und Emitterbahnwiderstände RE aus.

Die Bahnwiderstände RE, RC für Emitter und Kollektor entsprechend Fig. 2 werden also durch die Diffusionsgebiete der jeweiligen Emitterzonen 12 und Kollektorzonen 13 selbst gebildet, dass heißt sie sind in den entsprechenden Zonen 12, 13 mitintegriert. Diese Bahnwiderstände RE, RC erhält man dadurch, dass im Layout entsprechend Figur 3 künstlich die Abstände a am Emitter und die Abstände b am Kollektor eingeführt werden. Zwar müssen bei allen Kontaktierungen ebenfalls durch entsprechende Designregeln vorgegebene, laterale Mindestabstände eingehalten werden. Jedoch handelt es sich bei der erfindungsgemäßen Struktur gemäß Fig. 3 und 4 um Abstände a, b, die über die von den Designregeln verlangten und vorgegebenen Mindestabständen deutlich hinausgehen. Es wäre selbstverständlich auch denkbar, diese Bahnwiderstände RE, RC durch eigens diffundierte Widerstandsbereiche in den Halbleiterkörper 10 einzudiffundieren, jedoch wäre hier ein zusätzlicher Prozessschritt erforderlich und es ist gerade insbesondere aus ökonomischen Gründen fundamental bedeutend, dass die erfindungsgemäße ESD-Schutzstruktur auf möglichst einfache Weise und unter Vermeidung von zusätzlichen Prozessschritten herstellbar ist.

Nachfolgend wird die Funktionsweise der erfindungsgemäßen in der ESD-Struktur mitintegrierten Bahnwiderstände RE, RC näher beschrieben:

Über die Kollektorbahnwiderstände RC ist eine gleichmäßige Aufteilung des ESD-Stromes auf alle Bipolartransistoren T1 - T3 gewährleistet. Sollte jedoch durch einen der Bipolartransistoren T1 - T3 aus welchen Gründen auch immer geringfügig mehr Strom fließen, so fällt in gleichem Maße auch eine erhöhte Spannung an dem zugeordneten Kollektorbahnwiderstand RC ab, wodurch die Emitter-Kollektor-Spannung gedrosselt wird und was somit eine Reduzierung des Laststromes zur Folge hat. Auf diese Weise werden die Kollektorströme der Bipolartransistoren T1-T3 in gewissen Grenzen ausgeregelt, was zu einer höheren Stabilität der gesamten ESD-Schutzstruktur 7 führt. Insbesondere werden dadurch thermische Instabilitäten der ESD-Bipolartransistoren weitestgehend vermieden.

Über die Emitterwiderstände RE läßt sich in bekannter Weise die Verstärkung eines Transistors regeln. Der Kollektorstrom fließt im eingeschalteten Zustand auch durch den emitterseitigen Bahnwiderstand RE und erzeugt dort einen Spannungsabfall, so dass das Emitterpotential mit steigendem Strom ebenfalls ansteigt. Bei gleichbleibendem Basispotential ist somit die Basisemitterspannung reduziert. Eine dadurch resultierende Abnahme des Kollektorstromes führt zu einer Stromgegenkopplung. Die Verringerung der .effektiven Basisemitterspannung ist darüber hinaus für das Schaltverhalten der ESD-Schutzstruktur sehr bedeutend, da insbesondere die Haltespannung im Wesentlichen von den Emitterwiderständen RE, wie bereits eingangs erwähnt, abhängt. Durch die Reduzierung der effektiven Basisemitterspannung ist eine höhere Basisvorspannung erforderlich, wodurch vorteilhafterweise die Haltespannung der ESD-Schutzstruktur erhöht wird. Auf diese Weise kann über die Dimensionierung der emitterseitigen Bahnwiderstände RE ein sicherer Abstand der Haltespannung von dem Signalspannungsbereich auch bei kleinen Strukturgrößen von < 0,5 µm gewährleistet werden. Ohne solche Emittervorwiderstände RE könnte die gesamte ESD-Schutzstruktur 7 im zurückgeschnappten Zustand verharren, was zu einem Kurzschluss mit den eingangs genannten Folgen führen kann.

In Fig. 4 wurden die Abstände a, b im Wesentlichen gleich groß dargestellt. Es ist jedoch vorteilhaft, wenn die Kollektorabstände b sehr viel größer sind als die Emitterabstände a, so dass ein im Vergleich zum Emitterwiderstand RE sehr viel größerer Kollektorwiderstand RC erzeugt wird. Der Kollektorabstand b stellt somit gleichermaßen einen Sicherheitsabstand der Elektroden zum eigentlichen Kollektor dar. Typischerweise sollten alle Kollektorwiderstände RC gleichermaßen und alle Emitterwiderstände RE gleich groß sein.

Figur 5 zeigt in einer Draufsicht ein vorteilhaftes Layout einer ESD-Schutzstruktur 7 entsprechend Figur 2. Die gesamte ESD-Schutzstruktur 7 weist hier ein im Wesentlichen quadratisches Layout auf, das zusätzlich eine gleichmäßige Stromverteilung auf die verschiedenen Bipolartransistoren T1-T3 begünstigt. Durch das quadratische Layout, bei dem die Emitterzonen 13 und die Kollektorzonen 12 streifenförmig ausgebildet und parallel nebeneinander angeordnet sind, wird sichergestellt, dass keiner der Bipolartransistoren T1-T3 grundsätzlich andere Substrateffekte "zu sehen bekommt", als der jeweils benachbarte Bipolartransistor T1-T3. Darüber hinaus wird bei einem quadratischen Layout verhindert, dass der Spannungsabfall der Kontaktmetallisierung zu groß wird und dadurch eine ungleichmäßige Stromverteilung, wie dies beispielsweise bei einem stark rechteckförmigen Layout der Fall wäre, zustande kommt.

Die Erfindung ist jedoch nicht ausschließlich auf quadratische Layouts der ESD-Schutzstrukturen 7 beschränkt, sondern kann, wenngleich auch nicht so vorteilhaft, auch bei rechteckförmigen, runden oder ovalen, hexagonalen oder ähnlichen Layouts eingesetzt werden. Darüber hinaus müssen die Emitter- und Kollektorzonen 12, 13 nicht notwendigerweise streifenförmig und nebeneinander angeordnet sein, sondern können vorteilhafterweise auch kreisringförmig, quadratisch, mäanderförmig, fächerförmig oder ähnlich angeordnet sein. Vorteilhafterweise sind die Emitterzonen 13, Kollektorzonen 12 und Basiszonen 15 durch die jeweiligen Elektroden 18, 19, 20 soweit wie möglich durchgehend kontaktiert, um so eine weitere Homogenisierung des Stromflusses zu ermöglichen.

Figur 6 zeigt in einer Draufsicht eine vorteilhafte Anordnung der Leiterbahnen zur Kontaktierung der Emitterelektroden und der Kollektorelektroden.

Figur 6 zeigt dabei die beiden Metallisierungen für die Potentialschienen 4, 5. Ferner zeigt Figur 6 die jeweils streifenförmig und nebeneinander angeordneten Emitterelektroden 19 und Kollektorelektroden 18. Diese Elektroden 18, 19 sind über fingerförmige Metallisierungen 18', 19' mit der jeweils ihr zugeordneten Potentialschiene 4, 5 verbunden. Die Metallisierungsfinger 18', 19' sind ineinander verschränkt angeordnet und jeweils an den einander gegenüberliegenden Potentialschienen 4, 5 angeschlossen.

Die beim Betrieb der ESD-Schutzstruktur 7 an deren Elektroden 18, 19 unvermeidbaren Spannungsabfälle gestalten sich üblicherweise so, dass gerade an den Stirnenden der Elektroden 18, 19 die größten Spannungsdifferenzen zwischen Emitter und Kollektor auftreten, wodurch es dort zu den höchsten Stromdichten und somit zu durch Verbrennung bedingte Ausfällen der Elektroden 18, 19 kommen kann. Mit der entsprechend Figur 5 dargestellten Anordnung der Metallisierungsfinger 18', 19' ist dies weitestgehend ausgeschlossen, da die Metallisierungsfinger 18', 19' lediglich an einer der gegenüberliegenden Potentialschienen 4, 5 angeschlossen sind. Es treten hier zwar immer noch Spannungsabfälle entlang der jeweiligen Metallisierungen auf, jedoch treten diese im vorliegenden Ausführungsbeispiel bei einer abwechselnden Kollektorelektrode 18 und Emitterelektrode 19 in gegensinniger Richtung auf, so dass eine Spannungsdifferenz zwischen Kollektorelektrode 18 und Emitterelektrode 19 immer gleich bleibt. Darüber hinaus wird durch die layoutbedingte Maßnahme entsprechend Figur 5 eine homogenere Stromverteilung auf die gesamte Fläche der ESD-Schutzstruktur 7 begünstigt.

Ein weiteres Ausführungsbeispiel, das in den Figuren der Zeichnung nicht dargestellt wurde, bietet die Möglichkeit, dass eine ESD-Schutzstruktur nebeneinander beliebig häufig angeordnet wird. Es ist hier darauf zu achten, dass die p-dotierten Basiszonen 15 stets außen angeordnet sind und die Kollektorzonen 12 und Emitterzonen 13 umschließen. Dadurch, dass die Basiszonen 15 die Zonen 12, 13 vollständig umschließen, wird die ESD-Schutzstruktur 7 ringsherum auf einem definierten Potential gehalten, wodurch ein verbesserter Latch-Up-Schutz gewährleistet werden kann. Es wäre jedoch auch denkbar, dass die Basiszonen 15 die Zonen 12, 13 nicht vollständig umschließen, jedoch bietet eine solche Struktur ein geringeren latch-up-Schutz.

Die in den Ausführungsbeispielen beschriebene ESD-Schutzstruktur weist lediglich drei Bipolartransistoren T1 -T3 auf; im Layout weist diese ESD-Schutzstruktur somit drei Emitterfinger und zwei Kollektorfinger auf. Selbstverständlich lässt sich die vorliegende Erfindung auch mit mehr oder weniger Bipolartransistoren T1-T3 realisieren. Wesentlich ist hier lediglich die Symmetrierung, das heißt dass Emitterzonen 13 und Kollektorzonen 12 möglichst symmetrisch zueinander angeordnet sind. Darüber hinaus sollten die Emitter möglichst außen liegen, um parasitäre Randeffekte auszuschließen.

Die in den Figuren 3 und 4 gezeigten Basiszonen 15, Kollektorzonen 12 und Emitterzonen 13 können durch Diffusion oder durch Ionenimplanation in den Halbleiterkörper 10 eingebracht werden, jedoch richtet sich die verwendete Dotierungsmethode im Wesentlichen nach den jeweiligen Herstellungsprozessen zur Herstellung der integrierten Schaltung.

Für das Ausführungsbeispiel der Figuren 3 und 4 lassen sich selbstverständlich durch Austauschen der Leitfähigkeitstypen n gegen p neue mögliche Ausführungsbeispiele bereitstellen. Ferner soll der Vollständigkeit halber noch darauf hingewiesen werden, dass die lateralen und vertikalen Dimensionierungen in den Figuren 3 und 4 selbstverständlich nicht maßstabsgetreu dargestellt wurden. Vielmehr wurden zum Zwecke der besseren Übersicht die vertikalen Ausmaße im Vergleich zu den lateralen Dimensionen stark vergrößert dargestellt.

Die vorstehend beschriebene ESD-Schutzstruktur 7 vermeidet die eingangs genannten Probleme der thermischen Instabilität der Bipolartransistoren bzw. zu geringer Haltespannung mit einhergehender Zerstörung oder Beschädigung der ESD-Schutzstruktur. Diese Lösung des Problems wird nahezu ausschließlich mit Layoutmitteln erreicht und erfordert somit keine teuren Sonderprozesse oder Sondermasken. Es ist hier lediglich ein geringfügiger Mehraufwand an Chipfläche für die etwas breiter ausgebildeten Diffusionsgebiete erforderlich, wodurch jedoch die Selbstschutzwirkung der beschriebenen ESD-Schutzstruktur in erheblichen Maße gesteigert werden kann.

Die erfindungsgemäße ESD-Schutzstruktur eignet sich insbesondere bei MOS-/CMOS-integrierten Halbleiterschaltungen, die einen Schutz der Versorgungsspannungsleitungen und auch der Eingänge bzw. Ausgänge benötigen. Dies sind insbesondere alle integrierten Schaltungen mit analogen und digitalen Funktionen mit eigener analoger Versorgungsspannung, insbesondere solche Schaltungen, die mit hoher Betriebsspannung arbeiten und somit keinen Eigenschutz besitzen.

Zusammenfassend kann festgestellt werden, dass durch die wie beschrieben aufgebaute und betriebene erfindungsgemäße ESD-Schutzstruktur nahezu ohne Mehraufwand, dass heißt vorteilhafterweise durch einfaches Verbreitern der Diffusionsgebiete bzw. Implantationsgebiete ein optimaler ESD-Schutz mit einfachen Mitteln gewährleistet ist, ohne dass gleichzeitig die Nachteile der mit einer Vielzahl von Bipolartransistoren ausgestatteten ESD-Schutzstruktur nach dem Stand der Technik in Kauf genommen werden muss.

Die vorliegende Erfindung wurde anhand der vorstehenden Beschreibung so dargelegt, um das Prinzip der Erfindung und dessen praktische Anwendung am besten zu erklären. Selbstverständlich lässt sich die vorliegende Erfindung im Rahmen des fachmännischen Handelns in geeigneter Weise in mannigfaltigen Ausführungsformen und Abwandlungen realisieren.

### Bezugszeichenliste

- 1: integrierte Halbleiterschaltung
- 2: Versorgungsspannungseingang
- 3: Versorgungsspannungseingang
- 4: erste Potentialschiene
- 5: zweite Potentialschiene
- 6: zu schützende Schaltung
- 7: ESD-Schutzstruktur
- 10: Halbleiterkörper
- 10': Substratzone, Bereiche zwischen benachbarten Emitter- und Kollektorzonen
- 11: Oberfläche des Halbleiterkörpers
- 12: Kollektorzonen
- 13: Emitterzonen
- 14: Feldoxid
- 15: Basiszonen
- 16: Feldoxid
- 18: Kollektorelektrode
- 19: Emitterelektroden
- 20: Basiselektroden
- a: Abstand von Emitterelektrode zum Substrat
- b: Abstand von Kollektorelektrode zum Substrat
- B: Basisanschluss
- C: Kollektoranschluss
- E: Emitteranschluss
- RC: Kollektorbahnwiderstand
- RE: Emitterbahnwiderstand
- T1, T2, T3: Bipolartransistoren
- VCC: erstes Versorgungspotential
- VSS: zweites Versorgungspotential, Potential der Bezugsmasse

## Patentansprüche

1. ESD-Schutzstruktur zum Schutz einer zwischen einer ersten Potentialschiene (4) mit einem ersten Versorgungspotential (VCC) und einer zweiten Potentialschiene (5) mit einem zweiten Versorgungspotential (VSS) geschalteten, integrierten Halbleiterschaltung (1) vor elektrostatischer Entladung, mit einer Mehrzahl von lateral ausgebildeten Bipolartransistoren (7), deren Laststrecken parallel zueinander und zwischen den Potentialschienen (4, 5) angeordnet sind und deren Steueranschlüsse (B) an einer der Potentialschienen (4, 5) angeschlossen ist, wobei in die Laststrecke jedes Bipolartransistors (T1 - T3) jeweils ein kollektorseitig und/oder jeweils ein emitterseitig in die ESD-Schutzstruktur (7) mitintegrierter Bahnwiderstand (RC, RE) angeordnet ist.

2. ESD-Schutzstruktur nach Anspruch 1,
**dadurch gekennzeichnet, dass**
ein Halbleiterkörper (10) vorgesehen ist, in den mindestens eine Emitterzone (13) und mindestens eine Kollektorzone (12) des ersten Leitungstyps und mindestens eine Basiszone (15) des zweiten, entgegengesetzten Leitungstyps eingebettet sind, wobei die Zonen (12, 13) des ersten Leitungstyps abwechselnd nebeneinander angeordnet sind und die voneinander durch eine Substratzone (10') des zweiten Leitungstyps in der Weise beabstandet sind, dass sich ein Laststrompfad zwischen jeweils benachbarten Emitterzonen (12) und Kollektorzonen (13) ausbilden kann.

3. ESD-Schutzstruktur nach Anspruch 2,
**dadurch gekennzeichnet, dass**
auf jeder Emitterzone (13) jeweils eine Emitterelektrode (19) derart angeordnet ist, dass ein Abstand (a) zwischen Emitterelektrode (19) und dem pn-Übergang von Emitterzone (13) zur Substratzone (10') definiert ist, wobei der Abstand (a) ein Maß für den Widerstandswert des in der Emitterzone (13) mitintegrierten emitterseitigen Bahnwiderstandes (RE) ist.

4. ESD-Schutzstruktur nach einem der Ansprüche 2 oder 3,
**dadurch gekennzeichnet, dass**
auf jeder Kollektorzone (18) jeweils eine Kollektorelektrode (18) derart angeordnet ist, dass ein Abstand (b) zwischen Kollektorelektrode (19) und dem pn-Übergang von Kollektorzone (12) zur Substratzone (10') definiert ist, wobei der Abstand (b) ein Maß für den Widerstandswert des in der Kollektorzone (12) mitintegrierten kollektorseitigen Bahnwiderstandes (RC) ist.

5. ESD-Schutzstruktur nach einem der Ansprüche 2 bis 4,
**dadurch gekennzeichnet, dass**
die kollektorseitigen Bahnwiderstände (RC) sehr viel größer sind als die emitterseitigen Bahnwiderstände (RE).

6. ESD-Schutzstruktur nach einem der Ansprüche 2 bis 5,
**dadurch gekennzeichnet, dass**
die Basiszonen (15) die Emitterzonen (13) und die Kollektorzonen (13) lateral umschließen.

7. ESD-Schutzstruktur nach einem der Ansprüche 2 bis 6,
**dadurch gekennzeichnet, dass**
der Halbleiterkörper (10) Ladungsträger vom ersten Leitungstyp aufweist und in den Halbleiterkörper (10) mindestens eine weitere Wanne des zweiten Leitungstyps eingebettet ist, in der die Emitterzonen (13), Kollektorzonen (12) und Basiszonen (15) eingebettet sind.

8. ESD-Schutzstruktur nach einem der Ansprüche 2 bis 7,
**dadurch gekennzeichnet,dass**
die Emitterzonen (13) und Kollektorzonen (12) streifenförmig derart ausgebildet sind, dass sie abwechselnd nebeneinander und parallel zueinander angeordnet sind.

9. ESD-Schutzstruktur nach einem der vorstehenden Ansprüche,
**dadurch gekennzeichnet,dass**
die ESD-Schutzstruktur (7) ein im Wesentlichen quadratisches Layout aufweist.

10. ESD-Schutzstruktur nach einem der vorstehenden Ansprüche,
**dadurch gekennzeichnet,dass**
die Emitterzonen (13) von den Emitterelektroden (19) und die Kollektorzonen (12) von den Kollektorelektroden (18) durchgehend kontaktiert sind.

11. ESD-Schutzstruktur nach einem der vorstehenden Ansprüche,
**dadurch gekennzeichnet, dass**
die Emitterelektroden (19) und die Kollektorelektroden (18) über Leiterbahnen (19', 18') an jeweils einer gegenüberliegenden Potentialschiene (4, 5) angeschlossen sind und somit fingerförmige Anschlüsse bilden, die ineinander verschränkt sind.

12. ESD-Schutzstruktur nach einem der vorstehenden Ansprüche,
**dadurch gekennzeichnet,dass**
die Bipolartransistoren (T1 - T3) als Feldoxidtransisitoren ausgebildet sind.
